# FASCICULE DE BREVET EUROPEEN

(11) **EP 3 531 346 B1**
(45) Date de publication et mention de la délivrance du brevet: **14.10.2020**
(21) Numéro de dépôt: 19158403.6
(22) Date de dépôt: 20.02.2019
(51) Int. Cl.: G06K 19/07

(54) **INTERFACE DE COMMANDE RFID**
SCHNITTSTELLE EINER RFID-STEUERUNG
RFID CONTROL INTERFACE

(30) Priorité: 27.02.2018 FR 1851738
(43) Date de publication de la demande: 28.08.2019
(73) Titulaire: STMicroelectronics (Grenoble 2) SAS, 38000 Grenoble (FR); STMICROELECTRONICS (ROUSSET) SAS, 13790 Rousset (FR)
(72) Inventeur: MAILLET, Gwenael, 38000 GRENOBLE (FR); LABYRE, Jean-Louis, 38360 SASSENAGE (FR); BAS, Gilles, 30640 BEAUVOISIN (FR)
(74) Mandataire: Cabinet Beaumont

(56) Documents cités:
- FR-A1- 2 992 081
- US-A1- 2010 171 598
- US-A1- 2011 148 594
- Stmicroelectronics: "ST25DV02K-W1 ST25DV02K-W2 Dynamic NFC/RFID tag IC with 2-Kbit EEPROM with up to 2x pulse width modulation outputs", , 20 février 2018 (2018-02-20), XP055519031, Extrait de l'Internet: URL:https://www.st.com/resource/en/data_br ief/st25dv02k-w1.pdf [extrait le 2018-10-25]

## Description

### Domaine

La présente description concerne de façon générale les circuits électroniques et, plus particulièrement, les transpondeurs électromagnétiques ou étiquettes électroniques (tag) utilisant la technologie RFID (Radio Frequency Identification). La présente description s'applique plus particulièrement à la commande d'un équipement à partir d'une étiquette électronique.

### État de l'art antérieur

Les systèmes de communication à transpondeurs électromagnétiques sont de plus en plus fréquents, en particulier depuis le développement des technologies de communication en champ proche (Near Field Communication) équipant les téléphones mobiles notamment.

Ces systèmes exploitent un champ électromagnétique radiofréquence émis par un dispositif (terminal ou lecteur) pour communiquer avec un autre dispositif (carte ou étiquette). Un dispositif NFC comporte un circuit résonnant constitué d'une ou plusieurs antennes (éléments inductifs) et d'un ou plusieurs éléments capacitifs pour capter un champ électromagnétique. La tension récupérée aux bornes du circuit résonnant est exploitée par des circuits électroniques du dispositif ou transpondeur pour extraire l'énergie nécessaire à son fonctionnement, décoder des informations transmises via une modulation du champ électromagnétique, transmettre des informations en rétromodulation, etc.

La demande de brevet américaine US2010/0171598 Al décrit un système incluant un dispositif électronique et un dispositif RFID en communication électrique directe avec le dispositif électronique pour régler de manière sélective une tension ou un courant dans le dispositif électronique à un niveau parmi au moins trois niveaux différents. Dans les applications visées par la présente description, une étiquette électronique est destinée à capter des informations de commande ou de configuration à destination d'un équipement auquel cette étiquette est reliée. Ces informations doivent donc être converties en signaux interprétables par l'équipement (l'application) à commander.

### Résumé

Un mode de réalisation pallie tout ou partie des inconvénients des techniques connues de commande d'un équipement à partir d'informations reçues par communication en champ proche.

Un mode de réalisation propose une solution plus particulièrement adaptée à un système dans lequel la communication en champ proche sert à modifier une configuration ou un paramétrage de l'équipement.

Un mode de réalisation propose un circuit intégré d'interface entre un environnement de communication en champ proche et un environnement filaire de commande d'un équipement.

Ainsi, un mode de réalisation prévoit un circuit intégré selon la revendication 1.

Selon un mode de réalisation, le deuxième module est en logique câblée.

Selon un mode de réalisation, le premier module a accès à la mémoire en écriture et en lecture.

Selon un mode de réalisation, le deuxième module a accès à la mémoire uniquement en lecture.

Selon un mode de réalisation, le troisième module est une machine d'état en logique câblée.

Selon un mode de réalisation, le troisième module détecte la présence d'une tension sur des bornes d'alimentation du circuit.

Selon un mode de réalisation, le troisième module donne priorité au module ayant commencé un accès à la mémoire.

Selon un mode de réalisation, dont des bornes se répartissent exclusivement en :
deux bornes de connexion d'une antenne au premier module ;
deux bornes destinées à recevoir une tension continue d'un dispositif commandé par le ou les signaux PWM ; et
autant de bornes qu'il y a de signaux PWM générés.

Selon un mode de réalisation, le circuit est dépourvu de microprocesseur ou microcontrôleur.

Selon un mode de réalisation, la génération du signal PWM est modifiable lors d'une communication radiofréquence en champ proche.

Un mode de réalisation prévoit une interface de conversion de mots numériques de configuration d'au moins un signal PWM, comportant un circuit tel que ci-dessus.

Selon un mode de réalisation, l'interface comporte en outre une antenne de communication en champ proche.

Selon un mode de réalisation, le premier module tire l'énergie nécessaire à son fonctionnement d'un champ radiofréquence.

Selon un mode de réalisation, le deuxième module est exclusivement alimenté par un équipement auquel sont destinés les signaux PWM.

Un mode de réalisation prévoit un système comportant :
au moins une interface de conversion de mots numériques de configuration d'au moins un signal PWM ; et
au moins un équipement à commande électrique.

Un mode de réalisation prévoit un système comportant :
au moins une interface de conversion de mots numériques de configuration d'au moins un signal PWM ; et
au moins un moteur pas à pas ou un servomoteur à commande électrique.

Selon un mode de réalisation, le système comporte en outre un dispositif de communication en champ proche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation très schématique et sous forme de blocs d'un exemple de système du type auquel s'appliquent, à titre d'exemple, des modes de réalisation qui vont être décrits ;
la figure 2 est une représentation schématique et sous forme de blocs d'un mode de réalisation d'un circuit d'interface dans son environnement ;
la figure 3 représente, de façon très schématique et sous forme de blocs, un mode de réalisation d'un circuit intégré d'interface ;
la figure 4 représente, de façon très schématique et fonctionnelle, les sources d'alimentation des différents constituants du circuit d'interface ;
les figures 5A, 5B, 5C, 5D, 5E et 5F illustrent, par des chronogrammes et de façon très schématique, des situations de fonctionnement du circuit d'interface ;
les figures 6A, 6B, 6C, 6D, 6E, 6F et 6G illustrent, par des chronogrammes et de façon très schématique, d'autres situations de fonctionnement du circuit d'interface ;
les figures 7A et 7B illustrent, par des chronogrammes et de façon très schématique, un mode de mise en oeuvre d'un procédé de réduction de bruit ;
les figures 8A, 8B et 8C illustrent, par des chronogrammes et de façon très schématique, un autre mode de mise en oeuvre d'un procédé de réduction de bruit ;
les figures 9A et 9B illustrent, par des chronogrammes et de façon très schématique, encore un autre mode de mise en oeuvre d'un procédé de réduction de bruit ;
la figure 10 représente, de façon très schématique et sous forme de blocs, un système mettant en oeuvre tout ou partie des modes de réalisation décrits ;
la figure 10A illustre une variante du système de la figure 10 ;
la figure 11 représente, de façon très schématique et sous forme de blocs, un autre système mettant en oeuvre tout ou partie des modes de réalisation décrits ;
la figure 12 représente, de façon très schématique et sous forme de blocs, encore un autre système mettant en oeuvre tout ou partie des modes de réalisation décrits ; et
la figure 13 représente, de façon très schématique et sous forme de blocs, encore un autre système mettant en oeuvre tout ou partie des modes de réalisation décrits.

### Description détaillée

De mêmes éléments ont été désignés par de mêmes références aux différentes figures.

Par souci de clarté, seuls les étapes et éléments utiles à la compréhension des modes de réalisation qui vont être décrits ont été représentés et seront détaillés. En particulier, la génération des signaux radiofréquence et leur interprétation n'ont pas été détaillées, les modes de réalisation décrits étant compatibles avec les techniques usuelles de génération et d'interprétation de ces signaux. De plus, l'interprétation de signaux de commande par l'équipement n'a pas non plus été détaillée, les modes de réalisation décrits étant, là encore, compatibles avec les techniques usuelles.

Sauf précision contraire, lorsque l'on fait référence à deux éléments connectés entre eux, cela signifie directement connectés sans élément intermédiaire autre que des conducteurs, et lorsque l'on fait référence à deux éléments reliés ou couplés entre eux, cela signifie que ces deux éléments peuvent être directement reliés (connectés) ou être reliés par l'intermédiaire d'un ou plusieurs autres éléments.

Dans la description qui suit, lorsque l'on fait référence aux termes « approximativement », « environ » et « de l'ordre de », cela signifie à 10 % près, de préférence à 5 % près.

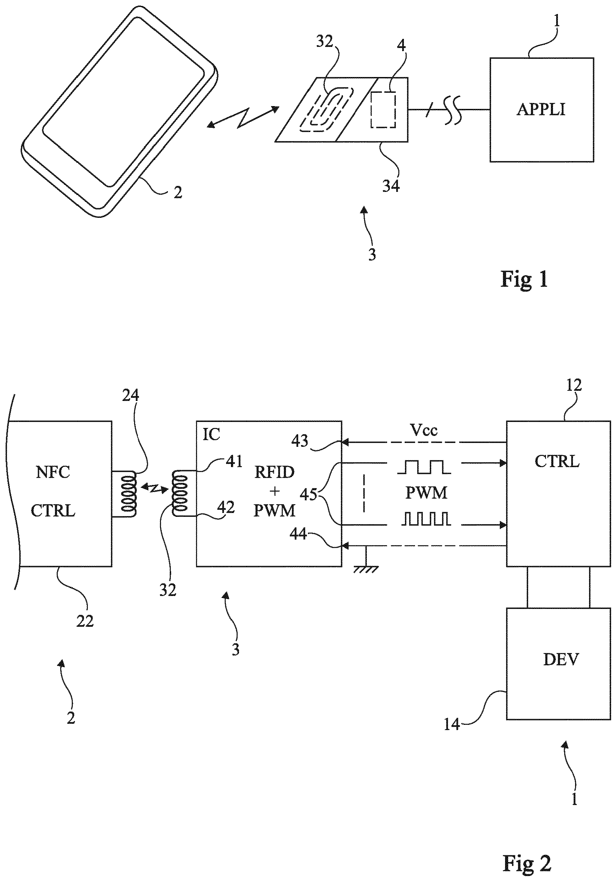

La figure 1 est une représentation très schématique et sous forme de blocs d'un mode de réalisation d'un système du type auquel s'appliquent, à titre d'exemple, des modes de réalisation qui vont être décrits.

Un tel système comporte :
- un équipement 1 (APPLI) à commander ou à configurer, fonction de l'application à laquelle est destiné le système ;
- un dispositif 2 équipé pour transmettre, en champ proche, des informations de commande, de configuration ou de paramétrage à destination de l'équipement 1 ; et
- une interface 3 apte à convertir les informations reçues en champ proche du dispositif 2 de commande en informations adaptées à être interprétées par l'équipement 1 à commander.

L'équipement 1 à commander est, par exemple, un dispositif ou circuit d'éclairage (par exemple à leds), un moteur électrique, par exemple un moteur linéaire ou un moteur pas à pas, une vanne de contrôle de circulation d'un fluide, un servomoteur, et plus généralement tout équipement susceptible d'être commandé, directement ou indirectement, par un signal électrique.

Le dispositif 2 de commande est, par exemple, un téléphone intelligent (smartphone) équipé d'un contrôleur NFC, un lecteur NFC dédié à l'application, et plus généralement tout dispositif (généralement dénommé lecteur ou terminal) équipé d'un circuit de génération et de modulation d'un champ radiofréquence de communication en champ proche à destination d'une étiquette électronique, de préférence un circuit compatible avec la norme ISO/IEC 15693, ou avec la norme ISO/IEC 14443. On fait référence à l'acronyme NFC pour désigner des communications en champ proche, mais cela ne signifie pas nécessairement selon le NFC-Forum. En effet, les modes de réalisation décrits sont plus généralement compatibles avec des communications radiofréquence, habituellement désignées par RFID ou NFC.

Dans les applications visées par la présente description, l'interface 3 est destinée à stocker des informations de commande ou de configuration envoyées à l'équipement à commander 1, par exemple sur requête, typiquement lors d'une mise sous tension ou d'un allumage ou d'une initialisation de l'équipement applicatif. Ainsi, l'interface 3 est équipée d'une mémoire de stockage non volatile d'informations de commande ou de configuration à destination de l'équipement 1.

Une solution aisée est de prévoir, dans l'interface 3, une étiquette électronique constituée d'un contrôleur NFC associé à une mémoire non volatile reprogrammable de stockage des informations de commande et de configuration, et un microcontrôleur ou microprocesseur de génération de signaux électriques de commande de l'équipement 1 à partir d'informations lues dans la mémoire de l'étiquette électronique. Toutefois, une telle solution est particulièrement onéreuse et requiert que le microcontrôleur soit programmé pour gérer les communications avec l'étiquette électronique.

Selon les modes de réalisation décrits, on prévoit de tirer profit du fait que, dans les systèmes visés, l'équipement à commander 1 n'a pas besoin de communiquer avec le dispositif de commande 2, c'est-à-dire d'envoyer des informations au dispositif 2. L'équipement 1 se contente d'extraire des informations de configuration et de commande de l'interface 3. En d'autres termes, la communication est unidirectionnelle du dispositif de commande 2 vers l'équipement à commander 1.

Ainsi, l'interface 3 comporte une antenne 32 (en pointillés en figure 1) et un circuit intégré 4 (également en pointillés en figure 1) capable de communiquer en champ proche avec le dispositif 2 et de fournir les commandes électriques à l'application, donc à l'équipement 1. Dans l'exemple représenté en figure 1, l'interface 3 est logée dans un boîtier 34, distinct du dispositif à commander. Toutefois, selon l'application, l'interface 3 peut être logée dans un boîtier ou une enceinte de l'équipement 1 à commander.

Une difficulté est cependant que l'interface 3 doit, quant à elle, échanger avec le dispositif de commande 2, ne serait-ce que pour être identifiée correctement par celui-ci et confirmer la réception correcte des informations reçues. Par ailleurs, l'interface 3 doit pouvoir être déclenchée par l'équipement à commander 1 pour fournir les informations mémorisées. Or, la mémoire de stockage des informations de commande ne peut pas, en même temps, être accédée par le dispositif 2 et être lue par l'équipement 1.

La figure 2 est une représentation schématique et sous forme de blocs d'un mode de réalisation d'une interface dans son environnement.

Selon ce mode de réalisation, le circuit intégré 4 (IC, RFID + PWM), constituant, avec l'antenne 32, l'interface 3, comporte :
- deux bornes 41 et 42 de connexion de l'antenne 32 ;
- deux bornes 43 et 44 destinées à recevoir une tension continue Vcc d'alimentation, l'une (44) de ces deux bornes définissant un potentiel de référence, typiquement la masse ; et
- au moins une borne 45 destinée à fournir un signal en modulation de largeur d'impulsions (PWM - Pulse Width Modulation) à un circuit électronique 12 (CTRL) de l'équipement 1.

Dans l'exemple représenté, plusieurs bornes 45 fournissent plusieurs signaux en modulation de largeur d'impulsions au dispositif 1. Le nombre de signaux dépend de l'application et différents exemples seront illustrés par la suite.

Le circuit 12, que comporte l'équipement 1, a pour fonction d'interpréter les signaux PWM reçus du circuit 4 pour commander un dispositif 14 (DEV) électrique de l'équipement (une lampe, un moteur, etc.). De préférence, la tension continue Vcc appliquée entre les bornes 43 et 44 est fournie par le (ou sous commande du) circuit 12. Cela permet, comme on le verra par la suite, de déclencher une lecture des informations stockées dans le circuit 4 sans signal de commande supplémentaire. Généralement, le circuit 12 ne stocke pas, de façon non volatile, les informations qu'il reçoit du circuit 4, mais ne comporte que des circuits de stockage volatile (par exemple des bascules ou des registres) et doit donc recevoir, à chaque mise sous tension ou réinitialisation, le ou les signaux PWM générés par le circuit 4.

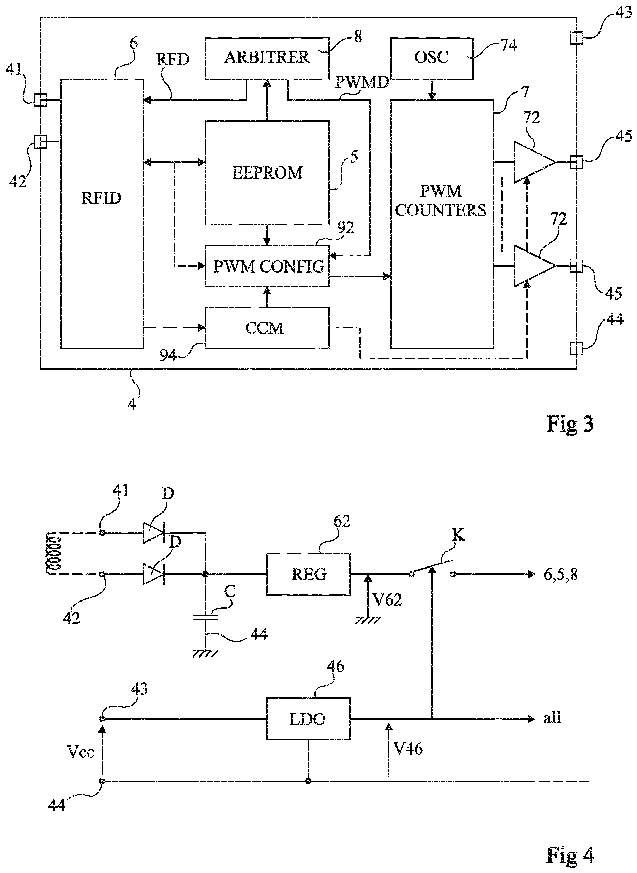

La figure 3 représente, de façon très schématique et sous forme de blocs, un mode de réalisation d'un circuit intégré d'interface 4, selon un aspect de la présente description.

La représentation de la figure 3 est fonctionnelle. En pratique, tous les éléments sont réalisés sous forme intégrée dans une même puce. De plus, pour simplifier, les signaux d'alimentation des différents constituants du circuit 4 ne sont pas illustrés en figure 3. Ces signaux d'alimentation sont cependant exposés ultérieurement.

Le circuit 4 comporte au moins :
- une mémoire non volatile reprogrammable 5, par exemple une mémoire EEPROM ou une mémoire flash ;
- un module 6 de communication radiofréquence en champ proche (RFID) ;
- un module logique 7 de génération de signaux PWM à partir de mots numériques de consigne contenus dans la mémoire 5 ;
- un module logique 8 (ARBITRER) d'allocation de la mémoire 5 à l'un ou l'autre des modules 6 ou 7 ; et
- un module logique 92 (PWM CONFIG) de configuration du module 7.

Le circuit 4 représenté en figure 3 comporte également, entre autres :
- un ou plusieurs amplificateurs 72 des signaux PWM générés par le module 7, les sorties des amplificateurs 72 étant reliées, de préférence connectées, aux bornes 45 ; et
- un oscillateur 74 (OSC) de génération d'un signal de séquencement du module 7.

En pratique, le module 7 est constitué d'un ensemble de compteurs, séquencés par l'oscillateur 4 et commandés par le module 92 à partir de mots que ce dernier lit dans la mémoire 5. La génération de signaux PWM à partir de mots numériques de paramétrage de ces signaux est en elle-même usuelle.

Le module RFID 6 est relié, de préférence connecté, aux bornes 41 et 42. Le module 6 constitue l'interface NFC du circuit 4. Le module 6 a, entre autres, pour rôle :
- de détecter un champ radiofréquence dans lequel le circuit 4 se trouve ;
- d'extraire de ce champ une tension d'alimentation au moins de la mémoire 5, du module 6 et du module 8 quand aucune tension n'est appliquée entre les bornes 43 et 45 ;
- de démoduler des informations présentes sur le signal radiofréquence émis par le dispositif 2 (figures 1 et 2) et de renvoyer, vers le dispositif 2, des informations contenues dans la mémoire, comme par exemple l'identifiant du circuit 4, ou d'envoyer au moins certaines des données à la mémoire 5 pour stockage ; et
- de générer des signaux de rétromodulation (de préférence par modulation de charge passive) du champ dans lequel l'interface 3 se trouve.

Les données stockées dans la mémoire 5 sont, entre autres :
- des informations de configuration radiofréquence, et en particulier un identifiant du circuit 4, afin de permettre à un lecteur de déterminer qu'il communique bien avec l'application souhaitée ;
- des informations de codage du ou des signaux PWM parmi lesquelles les fréquences, les rapports cycliques, et les rapports de phase de ces signaux PWM ; et
- des informations système ou utilisateur liées à l'application.

La mémoire 5 n'est lue par le module 92 qu'à chaque démarrage (boot) du circuit 4, déclenché par la présence d'une tension d'alimentation continue provenant de l'application, et n'est pas lue entre deux de ces démarrages ou initialisations. La mémoire 5 est lue par le module 6, à chaque démarrage (boot), qu'il soit provoqué par la présence d'une tension continue provenant de l'application ou lors d'une activation par le champ radiofréquence. En présence d'une activation par le champ radiofréquence, on extrait de la mémoire 5 des informations de configuration de la communication radiofréquence avec le module 6 ainsi que, par exemple, l'identifiant unique du circuit 4. La mémoire 5 n'est écrite que par le module 6.

Selon les modes de réalisation décrits, les modules 7, 8 et 92 sont des machines d'état en logique câblée, c'est-à-dire ne sont pas programmables (ils ne contiennent pas de registres), mais sont constitués de bascules et de fonctions de logique combinatoire (OU, ET, etc.).

Dans les modes de réalisation décrits, la mémoire 5 n'est lue par l'application qu'au démarrage ou la mise sous tension Vcc du circuit 4. De plus, cette mémoire n'est programmée que par le module 6.

Selon un mode de réalisation préféré, afin d'autoriser une modification des signaux PWM sans nécessiter un redémarrage du circuit 4, le module 92 reçoit (liaison en pointillés en figure 3) du module 6 les mots que ce module écrit dans la mémoire 5. De préférence, le module 92 ne modifie les signaux PWM (module 7) qu'une fois que l'écriture dans la mémoire 5 est terminée afin de garantir que la configuration (les signaux PWM) soit la même au prochain redémarrage. En variante, les signaux PWM sont modifiés en parallèle de l'écriture de la mémoire pour des applications dans lesquelles on accepte de revenir à la configuration précédente au cas où l'écriture dans la mémoire 5 échoue.

Comme mentionné précédemment, on doit éviter tout conflit d'accès à la mémoire 5. Cette fonction est assurée par le module 8 qui arbitre les accès à la mémoire.

Selon les modes de réalisation décrits, cet arbitrage est avantageusement effectué en détectant d'où provient l'énergie en premier et en donnant priorité au côté (RFID ou PWM) correspondant.

Cela constitue une solution particulièrement simple dans la mesure où plusieurs situations sont directement réglées selon que tel ou tel module est alimenté ou non.

La figure 4 représente, de façon très schématique et fonctionnelle, les sources d'alimentation des différents constituants du circuit d'interface 4.

Une tension d'alimentation peut provenir soit du champ électromagnétique généré par le terminal (2, figures 1 et 2), soit de l'application (1, figure 1).

De façon schématique, les bornes 41 et 42 sont couplées, par des éléments de redressement (des diodes D) à un régulateur 62 (REG), un élément capacitif C reliant les cathodes des diodes à la masse (borne 44). Le régulateur 62 peut être un simple limiteur ou un régulateur plus évolué. Une sortie du régulateur 62 alimente, en présence d'un champ radiofréquence, le module 6, la mémoire 5 et le module 8. La sortie du régulateur 62 est commandable par un interrupteur K, normalement fermé (normally-on). L'interrupteur K est commandé (ouvert) lorsqu'une tension Vcc est présente entre les bornes 43 et 44. Un régulateur linéaire 46, par exemple un régulateur à faible chute de tension série (LDO - Low Drop-Out), alimente, en présence d'une tension Vcc, tous (all) les constituants du circuit 4 avec une tension V46 et ouvre l'interrupteur K.

Ainsi, on voit déjà que la génération des signaux PWM et la lecture de la mémoire par le module 92 ne peut intervenir que lorsqu'une tension est présente entre les bornes 43 et 44. De plus, la génération des signaux PWM n'est présente que pendant que cette tension Vcc est présente.

Par contre, côté module 6, celui-ci est alimenté soit par le champ, soit par la tension Vcc.

Par conséquent, si le circuit 4 est démarré (alimenté) par la réception d'un signal radiofréquence, seul le module 6 a accès à la mémoire en lecture et en écriture. Si le circuit est démarré (alimenté) par la tension Vcc, tous les modules et composants sont alimentés. Par conséquent, la mémoire 5 est accessible par les modules 6 et 92 et un arbitrage peut être nécessaire, en particulier si un champ radiofréquence se présente également. Toutefois, la mémoire 5 n'est de préférence lue par le module 92 que lors du démarrage d'une alimentation par l'application. Par conséquent, bien que les signaux PWM soient fournis à l'application en permanence par le module 7 en présence de la tension Vcc, ils ne sont initialisés par le module 92 qu'au démarrage ou sur requête du module 6.

Le fonctionnement du module 8 est décrit par la suite de façon fonctionnelle à partir de chronogrammes illustrant différentes situations susceptibles de se produire.

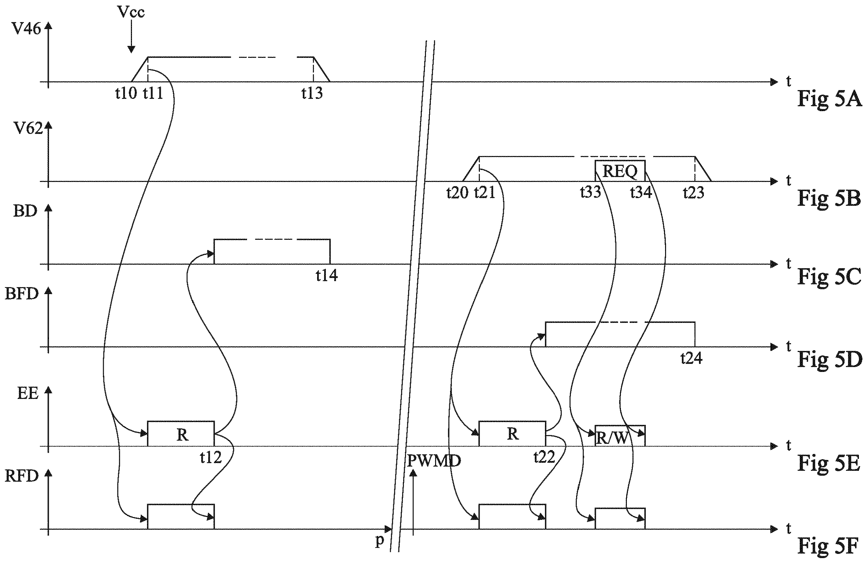

Les figures 5A, 5B, 5C, 5D, 5E et 5F illustrent, par des chronogrammes et de façon très schématique, des situations de fonctionnement du circuit d'interface 4.

Ces figures illustrent en particulier le fonctionnement du circuit 4 au démarrage dans deux cas non conflictuels selon lesquels le démarrage est effectué en présence de la tension Vcc seulement (partie gauche des chronogrammes) et en présence de la tension V62 (provenant du champ) seulement (partie droite des chronogrammes).

La figure 5A représente un exemple d'allure de la tension V46 fournie par le régulateur 46. La figure 5B représente un exemple d'allure de la tension V62 fournie par le régulateur 62. La figure 5C représente l'état d'un signal BD (Boot Done) indicateur d'un démarrage complet du circuit 4 (y compris des modules 6, 92 et 7). La figure 5D représente l'état d'un signal BFD (Boot Field Done) indicateur d'un démarrage du module 6 sous l'effet de la tension V46. La figure 5E représente les périodes d'accès à la mémoire 5 (EE). La figure 5F représente, en partie gauche, l'état d'un signal RFD (RF Disable) fourni, par le module 8 au module 6, de désactivation de la fonctionnalité radiofréquence et, en partie droite, l'état d'un signal PWMD (PMW Disable) fourni, par le module 6 au module 92, de désactivation de la fonctionnalité de lecture des données PWM dans la mémoire.

Le module 8 est alimenté, à la fois par la tension V46 et par la tension V62, de façon à être capable de commuter les états des signaux BDF, BD, RFD et PWMD notamment.

Par démarrage (boot), on entend que le module 6 ou 92 qui a accès à la mémoire 5 en lecture a terminé ses opérations sur cette mémoire.

En partie gauche des chronogrammes, on suppose que la tension Vcc est présente entre les bornes 43 et 44 à partir d'un instant t10. A un instant t11 ultérieur, le régulateur 46 a démarré et fournit une tension suffisante à l'alimentation des circuits. Dans cette configuration, à partir de l'instant t11, la mémoire (signal EE) est lue (R) pour extraire les informations de configuration des signaux PWM. Les mots binaires lus dans la mémoire par le module 92 permettent de paramétrer les compteurs du module 7 qui vont générer, avec le signal d'horloge de l'oscillateur 74, les signaux PWM à destination des amplificateurs 72. A un instant t12 où la mémoire a été lue et où les signaux PWM sont prêts, on considère que tous les modules sont prêts (signal BD à l'état actif). Afin d'éviter un conflit d'accès à la mémoire pendant que celle-ci est lue par le module 92, le module 8 désactive les fonctions radiofréquence du circuit 4 (signal RFD, figure 5F, à l'état haut) jusqu'à l'instant t12. En supposant qu'aucun lecteur ne soit présenté à l'interface 3, lorsque l'application est éteinte et que la tension Vcc disparaît (instant t13), le régulateur 46 n'est plus alimenté et les signaux BD et BFD redeviennent dans leur état inactif à un instant ultérieur t14 à partir duquel le régulateur 46 ne peut plus maintenir la tension d'alimentation.

En partie droite des chronogrammes, on suppose que la tension Vcc n'est pas présente entre les bornes 43 et 44, mais qu'à partir d'un instant t20 un champ radiofréquence est capté par l'antenne 32. A un instant t21 ultérieur, la tension V62 (par exemple régulée par le régulateur 62) est suffisante pour alimenter le module 6, la mémoire 5 et le module 8. Dans cette configuration, à partir de l'instant t21, la mémoire (signal EE) est lue (R) pour extraire les informations de configuration radiofréquence. A un instant t22 où la mémoire a été lue, le signal BFD indicateur d'un démarrage par la tension radiofréquence est activé. Afin d'éviter un conflit d'accès à la mémoire 5 pendant que celle-ci est lue par le module 6, le module 8 désactive (ou empêche d'activer) le module 92 (signal PWMD, figure 5F, à l'état haut) jusqu'à l'instant t22. On suppose qu'à un instant t33, le module 6 reçoit une requête REQ d'accès à la mémoire (lecture ou écriture) provenant du dispositif 2. A cet instant t33, le module 8 désactive (ou empêche d'activer) le module 92 (signal PWMD à l'état haut) afin d'éviter un conflit au niveau de la mémoire 5 et le module 6 peut donc communiquer avec la mémoire. Une fois l'accès terminé (instant t34), le signal PWMD est commuté vers son état de repos. On suppose que l'application n'initialise pas le circuit. Par conséquent, à un instant t24, postérieur à un instant t23, où le champ disparaît, la tension d'alimentation de la mémoire 5, du module 6 et du module 8 disparaît et le signal BFD revient à l'état bas.

Pour simplifier, on a négligé les décalages temporels liés aux propagations des signaux et aux commutations. En pratique, on s'assure qu'il n'y ait pas de conflit, en particulier au niveau des accès à la mémoire 5.

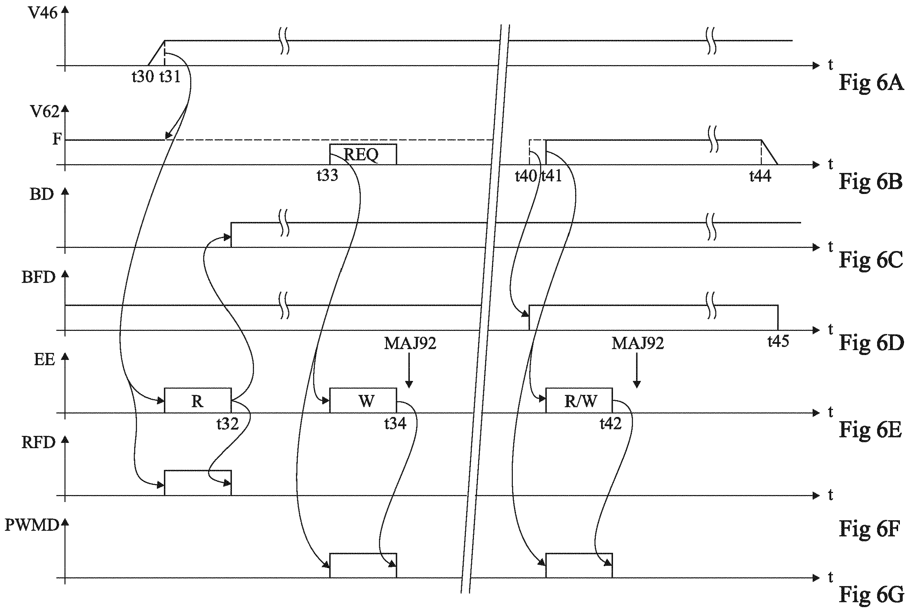

Les figures 6A, 6B, 6C, 6D, 6E, 6F et 6G illustrent, par des chronogrammes et de façon très schématique, d'autres situations de fonctionnement du circuit d'interface 4.

Ces figures illustrent en particulier le fonctionnement du circuit 4 en présence d'un conflit d'alimentation, c'est-à-dire si l'application fournit une tension Vcc alors que le circuit est alimenté par un champ (partie gauche des chronogrammes), ou si un lecteur cherche à programmer la mémoire alors que le circuit est alimenté par l'application (partie droite des chronogrammes). Comme pour les figures 5A à 5F, on néglige les légers décalages temporels entre les commutations.

La figure 6A représente un exemple d'allure de la tension V46 (Vcc) fournie par le régulateur 46. La figure 6B représente un exemple d'allure de la tension V62 fournie par le régulateur 62. La figure 6C représente l'état du signal BD (Boot Done) indicateur d'un démarrage complet du circuit 4 (y compris des modules 6, 92 et 7). La figure 6D représente l'état du signal BFD (Boot Field Done) indicateur d'un démarrage du module 6 sous l'effet de la tension V46. La figure 6E représente les périodes d'accès à la mémoire 5 (EE). La figure 6F représente l'état du signal RFD (RF Disable), fourni par le module 8 au module 6, de désactivation de la fonctionnalité radiofréquence. La figure 6G représente l'état du signal PWMD de désactivation du module 92 de lecture de la configuration PWM dans la mémoire 5.

En partie gauche des chronogrammes des figures 6A à 6G, on suppose que le circuit 4 est alimenté et a démarré sous l'effet du champ radiofréquence et que le champ est encore présent (état correspondant à celui de la partie droite des figures 5A à 5F entre les instants t22 et t23) . Ainsi, la tension V62 est présente, le signal BFD est actif et les signaux BD, RFD et PWMD sont inactifs. On suppose qu'à un instant t30, l'application fournit une tension Vcc. Dès que le régulateur 46 fournit une tension V46 de niveau suffisant (instant t31), l'interrupteur K (figure 4) est ouvert et l'alimentation de l'ensemble du circuit 4 est fournie par la tension V46. On suppose que le champ reste présent, de sorte que la tension V62 est toujours présente (illustrée en pointillés en figure 6B) mais n'est pas utilisée. A l'instant t31, la fonctionnalité radiofréquence est désactivée (signal RFD à l'état haut) de sorte que le module 6 ne peut plus lire ou écrire dans la mémoire 5. A partir de l'instant t31, le module 92 lit la configuration PWM dans la mémoire 5 et configure le module 7. Quand cette lecture est terminée et que le module 7 est configuré (instant t32), le signal BD commute à l'état actif et le signal RFD est désactivé, de façon à permettre au lecteur d'effectuer le cas échéant une programmation.

On suppose que le champ reste présent (le signal BFD reste actif) et qu'à un instant t33, le module 6 reçoit une requête d'écriture dans la mémoire provenant du lecteur. A cet instant t33, le module 8 désactive le module 92 afin d'éviter un conflit au niveau de la mémoire 5 et le module 6 peut donc communiquer avec la mémoire. Une fois l'écriture terminée (instant t34), il faut appliquer ces nouveaux paramètres PWM à l'application. Pour cela, les paramètres de configuration sont, de préférence, mis à jour dans le module 92 directement par le module 6. Cette mise à jour MAJ92 (flèche en figure 6E) n'intervient cependant, de préférence, qu'à la fin d'une période des signaux PWM, non représentés aux figures 6A à 6G.

Selon une variante non représentée, le module 8 désactive la fonctionnalité radiofréquence à l'instant t34 et provoque une nouvelle lecture, dans la mémoire, des paramètres de configuration par le module 92.

Les signaux BD et BFD sont respectivement commutés vers leur état inactif, comme exposé en relation avec les figures 5A à 5F, quand la tension Vcc ou le champ disparaît, ce qui n'est pas le cas en partie gauche des figures 6A à 6G où l'on considère que le champ et la tension Vcc restent présents.

En partie droite des chronogrammes des figures 6A à 6G, on suppose que le circuit 4 est alimenté par l'application (tension Vcc) mais n'est pas dans un champ radiofréquence (état correspondant à celui de la partie gauche des figures 5A à 5F entre les instants t12 et t13). Cela revient également à considérer que, à la suite de la partie gauche des figures 6A à 6G, le champ radiofréquence disparaît mais que la tension Vcc subsiste. Ainsi, la tension V46 est présente, le signal BD est actif et les signaux BFD, RFD et PWMD sont inactifs. On suppose qu'à un instant t40, un lecteur applique un champ radiofréquence pour modifier la configuration des signaux PWM. Dans la mesure où le module 6 est déjà initialisé par la présence de la tension V46, la présence du champ déclenche directement à l'instant t40 la commutation du signal BFD. Dès que la requête est démodulée par le module 6 (instant t41), le module 8 désactive le module 92 (signal PWMD actif) et donne l'accès à la mémoire au module 6. Le fonctionnement d'écriture par le module 6 (instants t41 à t42), puis de transfert (MAJ92) des nouveaux paramètres par le module 6 au module 92 pour les transférer en PWM à l'application est similaire à celui décrit en partie gauche des figures 6A à 6G. Dans la partie droite des chronogrammes des figures 6A à 6G, on suppose ensuite que le champ disparaît à un instant t44, provoquant la commutation vers l'état bas du signal BFD à un instant t45.

La réalisation du module 8 sous la forme d'une machine d'état en logique câblée est particulièrement simple. En effet, les commutations sont provoquées par la présence des tensions V62 et V46 ainsi que par les fins de cycles de la mémoire 5. Il est donc aisé de mettre en oeuvre les différentes situations fonctionnelles exposées ci-dessus en relation avec les figures 5A à 5F et 6A à 6G.

Un avantage des modes de réalisation décrits est qu'ils permettent de réduire la surface occupée par le circuit intégré par rapport à la surface nécessaire avec un microprocesseur ou microcontrôleur.

Un autre avantage est que la réalisation sous la forme de machines d'état en logique câblée évite des risques de dysfonctionnement liés à des erreurs d'exécution d'un programme, comme ce serait le cas avec un microprocesseur ou microcontrôleur.

Le fait d'intégrer, dans une même puce, les fonctions RFID et PWM risque, dans certains cas, d'engendrer une perturbation des signaux radiofréquence sous l'effet des signaux PWM. En effet, la proximité des modules 6 et 7 peut engendrer que les signaux PWM génèrent un bruit au niveau du module 6 qui perturbe les émissions-réceptions radiofréquence.

Ce problème de bruit est non seulement présent dans un circuit d'interface 4 tel que décrit en relation avec la figure 3, mais plus généralement dans tout système où des trains d'impulsions numériques (PWM) sont susceptibles de perturber des émissions-réceptions radiofréquence en raison de la proximité des circuits générant ces signaux respectifs. Cela peut être le cas, par exemple, d'un microcontrôleur générant des signaux PWM et monté à proximité d'un routeur ou contrôleur NFC, ou encore de deux circuits intégrés respectivement dédiés à une génération de signaux PWM et de signaux radiofréquence de communication en champ proche.

Les signaux RFID qui se situent dans une gamme de porteuses de transmission dans une gamme de 10-20 MHz, typiquement de l'ordre de 13,56 MHz avec des porteuses de modulation ou de rétromodulation de plusieurs centaines de kHz, typiquement de l'ordre de 847 kHz, de l'ordre de 484 KHz ou de l'ordre de 423 kHz sont particulièrement sensibles aux fréquences de plusieurs centaines de kHz, généralement utilisées pour des signaux PWM.

Ainsi, selon un autre aspect de la présente description, on prévoit d'intervenir, pendant les transmissions RFID, sur la génération des signaux PWM afin d'en réduire l'impact (le bruit).

Dans un circuit d'interface 4, tel que décrit en figure 3, le circuit intégré 4 comporte un module 94 introduisant au moins une contremesure au bruit pendant les émission-réception radiofréquence. Ce module 94 reçoit du module 6 une information comme quoi une transmission est présente et intervient sur un ou plusieurs modules, parmi le module 92, le module 7 ou les amplificateurs 72. La ou les contremesures sont appliquées dès qu'une requête est reçue d'un lecteur et jusqu'à ce que la transmission soit terminée. Cela peut correspondre à la fin d'une réponse par le circuit 4 vers le dispositif 2 ou à la fin d'une requête reçue du dispositif 2 si celle-ci n'appelle pas de réponse. Un module RFID est capable de déterminer, à la réception d'une requête, si celle-ci appelle une réponse ou non et peut donc déclencher le module 94 et l'arrêter une fois que la transmission radiofréquence est terminée.

Plus généralement, selon cet autre aspect, on prévoit, dans le circuit générant les impulsions en PWM ou dans un circuit voisin, un module introduisant une ou plusieurs contremesures au bruit.

On décrit par la suite un exemple appliqué au circuit 4, mais tout ce qui est décrit se transpose sans difficulté à d'autres circuits dans lesquels des problèmes similaires se posent. En particulier, on se place dans le cas de la génération d'un seul signal PWM mais tout ce qui est décrit s'applique quel que soit le nombre de signaux PWM générés.

Par exemple, on prévoit, dans le circuit 4, la possibilité de choisir une ou plusieurs contremesures qui sont intégrées dans le circuit. Ce choix dépend de l'application et est fixé, par exemple, dans une phase de personnalisation du circuit 4.

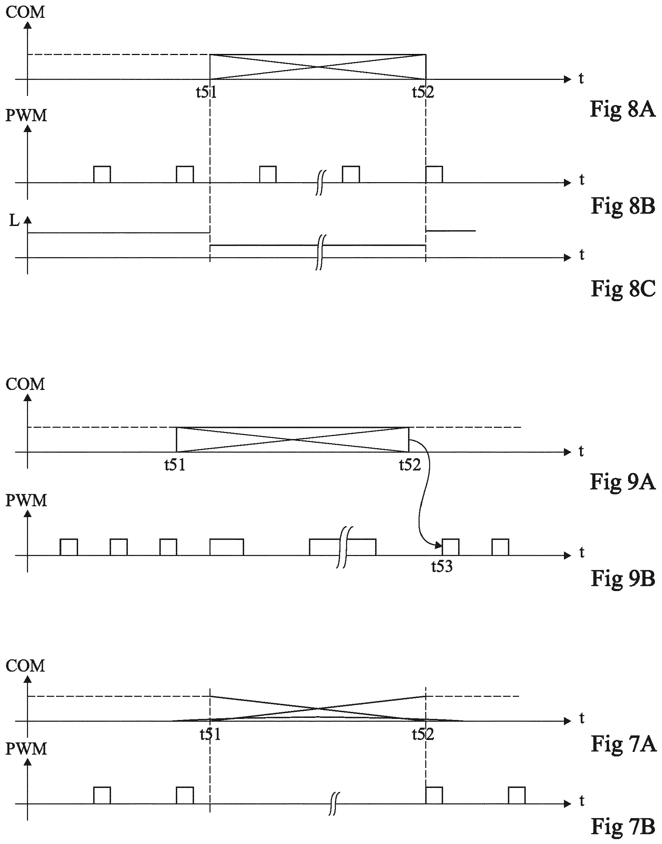

Les figures 7A et 7B illustrent, par des chronogrammes et de façon très schématique, un mode de mise en oeuvre d'un procédé de réduction de bruit.

La figure 7A illustre la présence d'une communication radiofréquence COM. La figure 7B illustre un exemple de signal PWM.

Selon ce mode de réalisation, on prévoit d'interrompre les signaux PWM pendant les périodes de transmission radiofréquence. Ainsi, entre des instants t51 et t52, il n'y a pas d'émission de signaux PWM à destination de l'application utilisant ces signaux. Cette interruption supprime le bruit de commutation des amplificateurs PWM et ainsi toute perturbation des signaux radiofréquence. L'interruption de tout signal PWM n'est généralement pas préjudiciable au fonctionnement de l'application dans la mesure où une communication RFID dure généralement moins de quelques millisecondes.

Pour interrompre les signaux PWM, on peut mettre en haute impédance des bornes 45 (sorties des amplificateurs 72) pendant la transmission. Cette mise en oeuvre requiert une liaison (en pointillés en figure 3) du module 94 vers les amplificateurs 72 afin de placer leurs sorties en haute impédance.

En variante, le module 94 intervient sur le module 7 pour placer les entrées qu'il reçoit du module 92 dans un état stable interrompant la génération des signaux PWM. Une telle variante est possible dans la mesure où le module 92, s'il ne lit la mémoire 5 qu'au démarrage, stocke le paramètre de façon volatile dans des bascules et les envoie en permanence au module 7.

Les figures 8A, 8B et 8C illustrent, par des chronogrammes et de façon très schématique, un autre mode de mise en oeuvre d'un procédé de réduction de bruit.

La figure 8A illustre la présence d'une communication radiofréquence COM. La figure 8B illustre un exemple de signal PWM. La figure 8C illustre le niveau L de sortie de l'amplificateur 72.

Selon ce mode de réalisation, on réduit le nombre d'étages de sortie utilisés par amplificateur 72 de façon à augmenter l'impédance des bornes 45 et réduire le niveau du bruit de commutation. On effectue ainsi en quelque sorte une variation de la puissance des signaux PWM selon que l'on est ou non en présence d'une transmission radiofréquence. On tire ici profit du fait que les amplificateurs de sortie 72 sont généralement pourvus de plusieurs étages de sortie en parallèle afin d'être capables de fournir les signaux avec les intensités requises.

Un tel mode de réalisation est compatible avec des applications dans lesquelles on ne souhaite pas interrompre complètement les signaux PWM.

Les figures 9A et 9B illustrent, par des chronogrammes et de façon très schématique, encore un autre mode de mise en oeuvre d'un procédé de réduction de bruit.

La figure 9A illustre la présence d'une communication radiofréquence COM. La figure 9B illustre un exemple de signal PWM.

Selon ce mode de réalisation, on prévoit de réduire, pendant les communications radiofréquence, la fréquence des signaux PWM, tout en conservant leur rapport cyclique (ou leur rapport de phase). Une telle réduction de fréquence permet de réduire les occurrences des bruits de communication et réduit ainsi les perturbations des signaux radiofréquence. A titre d'exemple particulier de réalisation, pour des signaux PWM à des fréquences normales de quelques dizaines de kHz, on peut, entre les instants t51 et t52, réduire la fréquence à quelques kHz.

Selon encore un autre mode de réalisation, on prévoit de combiner une réduction de puissance (figures 8A à 8C) et une réduction de fréquence (figures 9A et 9B).

Le fonctionnement redevient normal dès que la transmission radiofréquence est terminée. Toutefois, dans le cas d'une réduction de la fréquence, on veillera à préserver le rapport cyclique lorsque l'on réaugmente la fréquence. Ainsi, l'instant (t53) à partir duquel la fréquence redevient normale peut être postérieur à l'instant t52 de fin de communication.

Tout ou partie des contremesures au bruit peuvent être prévues dans le circuit 4.

Selon un autre aspect de la présente description, on prévoit un système de variation de puissance d'une charge électrique par signaux électriques en modulation de largeur d'impulsions (PWM), à commande radiofréquence en champ proche (RFID). Ainsi, on prévoit un système comportant une interface RFID ou NFC vers PWM, ce système comportant également un dispositif de commande en communication en champ proche et un équipement à commande électrique en PWM. De préférence, cette interface est unidirectionnelle, c'est-à-dire qu'elle est destinée à des applications dans lesquelles l'équipement n'a pas besoin de communiquer, au moins via l'interface, avec le dispositif de commande.

On décrit par la suite des exemples selon lesquels la mise en oeuvre pratique est effectuée par une interface 3 telle que décrite précédemment. Toutefois, les modes de réalisation décrits se transposent sans difficulté à d'autres réalisations pratiques respectant les fonctionnalités décrites.

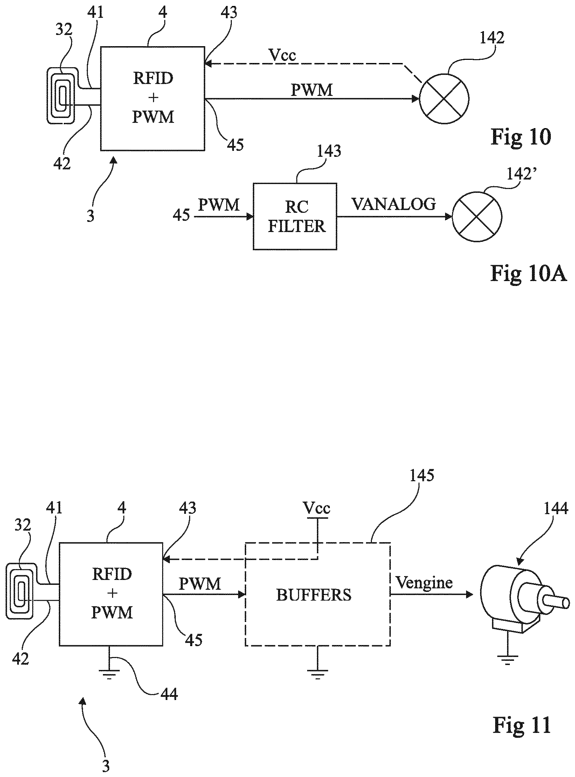

La figure 10 représente, de façon très schématique et sous forme de blocs, un système de variation de puissance d'une charge électrique constituée d'un circuit d'éclairage.

Selon cette réalisation, l'interface 3 est appliquée à la commande d'un circuit lumineux comportant une ou plusieurs lampes 142 (par exemple à base de diodes électroluminescentes, ou leds) afin de fournir une fonction de gradateur ou variateur d'intensité lumineuse. Dans l'exemple de la figure 10, la lampe 142 est adaptée à recevoir directement une consigne d'allumage/extinction et d'intensité lumineuse sous la forme d'un signal en modulation de largeur d'impulsions PWM. Le bloc lampe 142 (par exemple le circuit de commande ou driver des diodes) est alors relié, de préférence connecté, à une sortie 45 du circuit 4. La tension Vcc permettant d'alimenter la lecture de la mémoire 5 et la génération du signal PWM est, par exemple, fournie par le bloc lampe 142. Le cas échéant, plusieurs sorties PWM 45 du circuit 4 sont utilisées pour commander plusieurs blocs lampe 142.

Par rapport à une solution à gradateur résistif, la solution proposée ici apporte plus de précision. Par rapport à une solution à microcontrôleur, un avantage de la solution proposée est un moindre coût sans perdre de précision et une moindre consommation d'énergie. De plus, la solution proposée de signal PWM est compatible avec des fonctions d'allumage en tout ou rien (1 ou 0).

La figure 10A représente, de façon partielle, une variante selon laquelle le bloc lampe 142' a besoin d'un signal analogique VANALOG de commande d'intensité lumineuse. On prévoit alors d'intercaler un filtre passe-bas 143 (RC FILTER), par exemple une cellule résistive et capacitive, afin de convertir le signal numérique PWM en niveau analogique.

La figure 11 représente, de façon très schématique et sous forme de blocs, un autre système de variation de puissance d'une charge électrique constituée d'un moteur électrique à courant continu.

Selon cette réalisation, l'interface 3 est appliquée à la commande d'un moteur 144, par exemple à commande continue Vengine telle que représentée ou à commande directe en PWM. Le cas échéant (selon le courant requis pour le moteur), on intercale des amplificateurs 145 (buffers) également alimentés par la tension Vcc, alors fournie en borne 43 du circuit 4.

Un avantage de cette solution est une grande précision de commande de la vitesse moteur, compatible avec une commande par communication en champ proche. Par rapport à une solution résistive, on gagne en précision et, par rapport à une solution à microcontrôleur, on gagne en coût et en énergie.

Selon d'autres modes de réalisation de variation de puissance par commande RFID de signaux électriques en mode PWM (non représentés), le signal PWM commande une variation de volume sonore, un circuit à entrées-sorties programmées (Programmed Input/Output Controller), et plus généralement tout équipement adapté à une commande électrique en variation de puissance.

Selon un autre aspect de la présente description, on prévoit un système de commande, par signaux radiofréquence en champ proche (RFID), d'un actionneur (servomoteur) ou moteur pas à pas à commande électrique. Ainsi, on prévoit un système comportant une interface RFID ou NFC vers PWM, ce système comportant également un dispositif de commande en communication en champ proche et un équipement à commande électrique en PWM. Comme pour les modes de réalisation à variation de puissance, cette interface est, de préférence, unidirectionnelle, c'est-à-dire qu'elle est destinée à des applications dans lesquelles l'équipement n'a pas besoin de communiquer, au moins via l'interface, avec le dispositif de commande.

Comme pour l'aspect précédent, on décrit par la suite des exemples selon lesquels la mise en oeuvre pratique est effectuée par une interface 3 telle que décrite précédemment. Toutefois, les modes de réalisation décrits se transposent sans difficulté à d'autres réalisations pratiques respectant les fonctionnalités décrites.

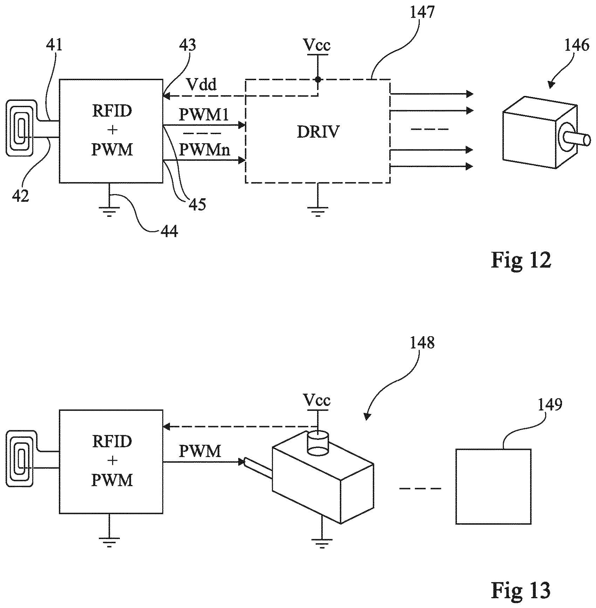

La figure 12 représente, de façon très schématique et sous forme de blocs, un système de commande d'un moteur pas à pas par signaux PWM.

Selon cette réalisation, l'interface 3 est appliquée à la commande d'un moteur pas à pas 146. Dans ce cas, on utilise plusieurs sorties PWM 45 du circuit 4 et les signaux PWM générés sont également prévus pour un contrôle de phase. Le nombre de signaux PWM utilisés dépend de l'application et des signaux de commande requis par le moteur pas à pas 146. De préférence, un circuit d'amplification 147 (DRIV) est intercalé entre le circuit 4 et le moteur 146.

Un avantage de cette solution est, outre tout ou partie des avantages décrits en relation avec les autres applications, une commande de grande précision à faible coût.

La figure 13 représente, de façon très schématique et sous forme de blocs, encore un autre système de commande par signaux PWM d'un actionneur électrique de type servomoteur.

Selon cette réalisation, l'interface 3 est appliquée à la commande d'un objet mécanique 149 par un servomoteur 148. La position mécanique du servomoteur dépend du rapport cyclique du signal PWM. On tire alors profit de pouvoir effectuer, par une interface NFC, une commande directe, précise et à moindre coût. L'objet commandé 149 peut être une vanne, une serrure, et plus généralement tout objet habituellement commandable par un servomoteur.

Divers modes de réalisation ont été décrits. Diverses modifications apparaîtront à l'homme de l'art. En particulier, le choix de la fréquence des signaux en modulation de largeur d'impulsions peut être différent d'une application à une autre. Par ailleurs, bien que dans un mode de réalisation préféré, la génération des signaux PWM est fournie (le module 7 fournit les signaux PWM) pendant tout le temps où le circuit est alimenté (à l'exception de certaines des contremesures au bruit décrites), on pourra prévoir que la génération des signaux PWM n'intervienne qu'au démarrage. En outre, bien que les modules 7 et 92 aient été décrits comme deux modules distincts, il peut s'agir d'un seul et même module. Enfin, la mise en oeuvre pratique des modes de réalisation qui ont été décrits est à la portée de l'homme du métier en utilisant les indications fonctionnelles données ci-dessus.

## Revendications

1. Circuit intégré comportant :
un premier module (6) de communication en champ proche, et un deuxième module (7, 92) de génération d'au moins un signal en modulation de largeur d'impulsions (PWM) ;
une mémoire non volatile (5) contenant au moins des mots numériques de configuration du ou des signaux PWM ;
**caractérisé en ce que** le circuit intégré comporte :
un troisième module (8), différent du deuxième module (7, 92), d'affectation de la mémoire (5) au premier module (6) ou au deuxième module.

2. Circuit selon la revendication 1, dans lequel le deuxième module est en logique câblée.

3. Circuit selon la revendication 1 ou 2, dans lequel le premier module (6) a accès à la mémoire en écriture et en lecture.

4. Circuit selon l'une quelconque des revendications 1 à 3, dans lequel le deuxième module (7, 92) a accès à la mémoire uniquement en lecture.

5. Circuit selon l'une quelconque des revendications 1 à 4, dans lequel le troisième module (8) est une machine d'état en logique câblée.

6. Circuit selon l'une quelconque des revendications 1 à 5, dans lequel le troisième module (8) détecte la présence d'une tension sur des bornes d'alimentation du circuit.

7. Circuit selon l'une quelconque des revendications là 6, dans lequel le troisième module (8) donne priorité au module ayant commencé un accès à la mémoire.

8. Circuit selon l'une quelconque des revendications 1 à 7, dont des bornes se répartissent exclusivement en :
deux bornes (41, 42) de connexion d'une antenne (32) au premier module (6) ;
deux bornes (43, 44) destinées à recevoir une tension continue (Vcc) d'un dispositif (1) commandé par le ou les signaux PWM ; et
autant de bornes (45) qu'il y a de signaux PWM générés.

9. Circuit selon l'une quelconque des revendications 1 à 8, dépourvu de microprocesseur ou microcontrôleur.

10. Circuit selon l'une quelconque des revendications 1 à 9, dans lequel la génération du signal PWM est modifiable lors d'une communication radiofréquence en champ proche.

11. Interface (3) de conversion de mots numériques de configuration d'au moins un signal PWM, comportant un circuit (4) selon l'une quelconque des revendications 1 à 10.

12. Interface selon la revendication 11, comportant en outre une antenne (32) de communication en champ proche.

13. Interface selon la revendication 11 ou 12, dans laquelle le premier module (6) tire l'énergie nécessaire à son fonctionnement d'un champ radiofréquence.

14. Interface selon l'une quelconque des revendications 11 à 13, dans laquelle le deuxième module (7, 92) est exclusivement alimenté par un équipement (1) auquel sont destinés les signaux PWM.

15. Système comportant :
au moins une interface (3) selon l'une quelconque des revendications 11 à 14 ; et
au moins un équipement à commande électrique (142 ; 142' ; 144 ; 146 ; 148).

16. Système comportant :
au moins une interface (3) selon l'une quelconque des revendications 11 à 14 ; et
au moins un moteur pas à pas ou un servomoteur à commande électrique (146 ; 148).

17. Système selon la revendication 15 ou 16, comportant en outre un dispositif (2) de communication en champ proche.

## Patentansprüche

1. Eine integrierte Schaltung, die Folgendes aufweist:
eine erste Nahfeld-Kommunikationseinheit (6) und eine zweite Einheit (7, 92) zum Erzeugen mindestens eines Signals in Pulsbreitenmodulation (PWM);
einen nichtflüchtigen Speicher (5), der mindestens digitale Wörter zum Konfigurieren des/der PWM-Signals/-Signale enthält;
**dadurch gekennzeichnet, dass** die integrierte Schaltung Folgendes aufweist:
eine dritte Einheit (8), die sich von der zweiten Einheit (7, 92) unterscheidet, um den Speicher (5) der ersten Einheit (6) oder der zweiten Einheit zuzuordnen.

2. Schaltung nach Anspruch 1, wobei die zweite Einheit in verdrahteter Logik ist.

3. Schaltung nach Anspruch 1 oder 2, wobei die erste Einheit (6) im Schreib- und im Lesemodus Zugriff auf den Speicher hat.

4. Schaltung nach einem der Ansprüche 1 bis 3, wobei die zweite Einheit (7, 92) nur im Lesemodus Zugriff auf den Speicher hat.

5. Schaltung nach einem der Ansprüche 1 bis 4, wobei die dritte Einheit (8) eine Zustandsmaschine in verdrahteter Logik ist.

6. Schaltung nach einem der Ansprüche 1 bis 5, wobei die dritte Einheit (8) das Vorhandensein einer Spannung an den Stromversorgungsanschlüssen der Schaltung detektiert.

7. Schaltung nach einem der Ansprüche 1 bis 6, wobei die dritte Einheit (8) der Einheit, die einen Zugriff auf den Speicher gestartet hat, Priorität einräumt.

8. Schaltung nach einem der Ansprüche 1 bis 7, deren Anschlüsse ausschließlich wie folgt verteilt sind:
zwei Anschlüsse (41, 42) für den Anschluss einer Antenne (32) an die erste Einheit (6);
zwei Anschlüsse (43, 44), die dazu bestimmt sind, eine Gleichspannung (Vcc) von einer Vorrichtung (1) zu empfangen, die durch das/die PWM-Signal/ -Signale gesteuert wird; und
so viele Anschlüsse (45), wie PWM-Signale erzeugt werden.

9. Schaltung nach einem der Ansprüche 1 bis 8, die keinen Mikroprozessor oder Mikrocontroller enthält.

10. Schaltung nach einem der Ansprüche 1 bis 9, wobei die Erzeugung des PWM-Signals während einer Nahfeld-Hochfrequenzkommunikation modifiziert werden kann.

11. Eine Schnittstelle (3) zum Umwandeln digitaler Konfigurationswörter von mindestens einem PWM-Signal, die die Schaltung (4) nach einem der Ansprüche 1 bis 10 aufweist.

12. Schnittstelle nach Anspruch 11, die ferner eine Nahfeld-Kommunikationsantenne (32) aufweist.

13. Schnittstelle nach Anspruch 11 oder 12, wobei die erste Einheit (6) die für ihren Betrieb erforderliche Leistung aus einem Hochfrequenzfeld bezieht.

14. Schnittstelle nach einem der Ansprüche 11 bis 13, wobei die zweite Einheit (7, 92) ausschließlich von einem Gerät (1) gespeist wird, für das die PWM-Signale bestimmt sind.

15. Ein System, das Folgendes aufweist:
mindestens eine Schnittstelle (3) nach einem der Ansprüche 11 bis 14; und
mindestens ein elektrisch gesteuertes Gerät (142; 142'; 144; 146; 148).

16. Ein System, das Folgendes aufweist:
mindestens eine Schnittstelle (3) nach einem der Ansprüche 11 bis 14; und
mindestens einen elektrisch gesteuerten Schrittmotor oder Servomotor (146; 148).

17. System nach Anspruch 15 oder 16, das ferner eine Nahfeld-Kommunikationseinrichtung aufweist (2).

## Claims

1. An integrated circuit comprising:
a first near-field communication unit (6) and a second unit (7, 92) for generating at least one signal in pulse-width modulation (PWM);
a non-volatile memory (5) containing at least digital words for configuring the PWM signal(s);
**characterized in that** the integrated circuit comprises:
a third unit (8), different from the second unit (7, 92), for assigning the memory (5) to the first unit (6) or to the second unit.

2. The circuit of claim 1, wherein the second unit is in wired logic.

3. The circuit of claim 1 or 2, wherein the first unit (6) has access to the memory in write and in read mode.

4. The circuit of any of claims 1 to 3, wherein the second unit (7, 92) has access to the memory in read mode only.

5. The circuit of any of claims 1 to 4, wherein the third unit (8) is a state machine in wired logic.

6. The circuit of any of claims 1 to 5, wherein the third unit (8) detects the presence of a voltage on power supply terminals of the circuit.

7. The circuit of any of claims 1 to 6, wherein the third unit (8) gives priority to the unit having started an access to the memory.

8. The circuit of any of claims 1 to 7, having terminals exclusively distributed into:
two terminals (41, 42) of connection of an antenna (32) to the first unit (6);
two terminals (43, 44) intended to receive a DC voltage (Vcc) from a device (1) controlled by the PWM signal(s); and
as many terminals (45) as there are generated PWM signals.

9. The circuit of any of claims 1 to 8, comprising no microprocessor or microcontroller.

10. The circuit of any of claims 1 to 9, wherein the generation of the PWM signal can be modified during a near field radio frequency communication.

11. An interface (3) for converting digital words of configuration of at least one PWM signal, comprising the circuit (4) of any of claims 1 to 10.

12. The interface of claim 11, further comprising a near-field communication antenna (32).

13. The interface of claim 11 or 12, wherein the first unit (6) draws the power necessary to its operation from a radio frequency field.

14. The interface of any of claims 11 to 13, wherein the second unit (7, 92) is exclusively powered by equipment (1) for which the PWM signals are intended.

15. A system comprising:
at least one interface (3) of any of claims 11 to 14; and
at least one electrically controlled piece of equipment (142; 142'; 144; 146; 148).

16. A system comprising:
at least one interface (3) of any of claims 11 to 14; and
at least one electrically controlled stepping motor or servomotor (146; 148).

17. The system of claim 15 or 16, further comprising a near-field communication device (2).
